# EUROPÄISCHE PATENTSCHRIFT

(11) **EP 2 047 176 B1**
(45) Veröffentlichungstag und Bekanntmachung des Hinweises auf die Patenterteilung: **30.03.2016**
(21) Anmeldenummer: 07787030.1
(22) Anmeldetag: 04.07.2007
(51) Int. Cl.: F24C 15/10, H03K 17/97, F24C 7/08

(54) **KOCHFELD**
COOKING HOB
PLAQUE DE CUISSON

(30) Priorität: 25.07.2006 DE 102006034391
(43) Veröffentlichungstag der Anmeldung: 15.04.2009
(60) Teilanmeldung: 10177070.9
(73) Patentinhaber: BSH Hausgeräte GmbH, 81739 München (DE)
(72) Erfinder: KNOELLER, Thomas, 76135 Karlsruhe (DE)
(86) Internationale Anmeldenummer: PCT/EP2007/056710
(87) Internationale Veröffentlichungsnummer: WO 2008/012177

(56) Entgegenhaltungen:
- EP-A- 0 962 707
- EP-A2- 1 349 281
- WO-A-2004/038298
- WO-A-2005/050846
- WO-A-2006/108619
- DE-A1-102005 049 995
- DE-A1-102007 056 416
- DE-C1- 10 063 693
- GB-A- 2 173 579
- US-A- 5 959 863
- US-A1- 2002 054 012

## Beschreibung

Die Erfindung geht aus von einem Kochfeld nach dem Oberbegriff des Anspruchs 1.

Aus der DE 102 12 929 A1 ist eine Bedienvorrichtung für ein Kochfeld mit einem Bedienknebel mit wenigstens einem zumindest magnetisierbaren Element zum Positionieren des Bedienknebels an einer definierten Position des Kochfelds durch eine Magnetkraft bekannt. Der Bedienknebel weist eine sich in einer Standebene erstreckende Standfläche zum Abstützen auf dem Kochfeld in einer Ruheposition auf. Durch ein Verschieben des Bedienknebels auf dem Kochfeld in eine entsprechende Richtung gegen die der Magnetkraft entsprechende Rückstellkraft kann eine Kochzone ausgewählt werden und durch Drehen des Bedienknebels kann eine Heizleistung der entsprechenden Kochzone eingestellt werden.

Der nächstliegende Stand der Technik is aus WO 2004/038298 bekannt.

Die Aufgabe der Erfindung besteht insbesondere darin, ein gattungsgemäßes Kochfeld bereitzustellen, durch die Schleifspuren im Bereich der vorgegebenen Position des Bedienknebels auf dem Kochfeld vermieden werden können und durch die ein besonders hoher Bedienkomfort erreichbar ist.

Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einem Kochfeld mit einem Bedienknebel mit wenigstens einem zumindest magnetisierbaren Element zum Positionieren des Bedienknebels an einer definierten Position des Kochfelds durch eine Magnetkraft und mit einer sich in einer Standebene erstreckenden Standfläche zum Abstützen auf dem Kochfeld in einer Ruheposition.

Es wird vorgeschlagen, dass das kochfeld eine die Standfläche umgebende Auflagefläche zum Abstützen des Bedienknebels in einer Kippposition umfasst, wobei die

Auflagefläche in der Ruheposition der Standebene der Standfläche zugewandt ist und von dieser zumindest in einem Teilbereich beabstandet ist. Durch die erfindungsgemäße Gestaltung wird eine Kippbewegung des Bedienknebels ermöglicht, die dank der Auflagefläche begrenzt und damit gut kontrollierbar ist. Die Auflagefläche kann so gestaltet sein, dass ein Bewegungsspielraum der Kippbewegung nicht so groß ist, dass ein Impuls, mit dem die Auflagefläche auf dem Kochfeld auftrifft, zu einem Schaden des Kochfelds führen kann. Der Freiheitsgrad der Kippbewegung kann vorteilhaft in der Bedienung des Kochfelds das aus dem Stand der Technik bekannte Verschieben des Bedienknebels in der Standebene ersetzen, so dass während einer normalen Benutzung des Bedienknebels ein Verschieben desselben entfallen kann. Dadurch wird die Häufigkeit der Verschiebebewegungen reduziert, und Schleifspuren auf dem Kochfeld, welches besonders vorteilhaft aus Glaskeramik gebildet ist, können vermieden werden. Durch das Vermeiden der Schleifspuren kann zudem die Lebensdauer des Kochfelds verlängert werden.

Eine Auflagefläche mit guten Reinigungseigenschaften kann erreicht werden, wenn die Auflagefläche konvex zur Standebene hin gewölbt ist. Als konvex soll in diesem Zusammenhang eine Fläche bezeichnet werden, die in zumindest einer Richtung konvex ist. Durch die konvexe Form kann ein Abrollen des Bedienelements auf der Kochfläche ermöglicht werden. Dadurch können Beschädigungen und Schleifspuren noch effektiver vermieden werden.

Eine in der Kipprichtung stabile Kippposition des Bedienknebels kann gewährleistet werden und eine linienförmige Auflage der Auflagefläche auf dem Kochfeld kann erreicht werden, wenn die Auflagefläche die Form eines Ausschnitts aus einem Kegelmantel hat.

Ein eng begrenzter Bewegungsspielraum kann erreicht werden, wenn die Auflagefläche bezogen auf die Standebene einen Neigungswinkel von weniger als 10° hat. Durch den eng begrenzten Bewegungsspielraum können Schäden der Kochfläche durch ein hartes, schwungvolles Aufschlagen der Auflagefläche auf dem Kochfeld vermieden werden, wodurch die Lebensdauer des Kochfelds weiter erhöht werden kann. In der bevorzugten Ausführungsform beträgt der Neigungswinkel 6°.

Da die Standfläche erfindungsgemäß kreisförmig und eben ist, kann der Bedienknebel einfach in alle möglichen Richtungen gekippt werden und Ecken am Rand der Standfläche können vermieden werden. Der Durchmesser der Standfläche beträgt weniger als 20 mm, besonders vorteilhaft 10 mm, so dass ein einfaches Verkippen mit einem Finger möglich ist.

Umfasst der Bedienknebel eine der Standfläche gegenüberliegende Berührfläche, die um ein Vielfaches größer ist als die Standfläche, ist ein leichtes Verkippen des Bedienknaufs durch ein Berühren insbesondere des Rands der Berührfläche möglich. Durch die Größenverhältnisse bestehen für den Bediener vorteilhafte Hebelverhältnisse.

Neben einem ansprechenden Design kann eine von der absoluten Drehposition des Bedienknebels unabhängige Position dadurch gewährleistet und auch visualisiert werden, dass zumindest die Außenfläche des Bedienknebels um eine senkrecht zur Standfläche verlaufende Rotationsachse rotationssymmetrisch ist.

Umfasst der Bedienknebel eine Mehrzahl von gleichmäßig um eine senkrecht zur Standfläche verlaufende Rotationsachse verteilten Magneten, kann eine Rotationsbewegung des Bedienknebels einfach mit Hilfe von Hallsensoren oder geeigneten induktiven Sensoren erkannt werden.

Wenn zumindest die Außenhülle des Bedienknebels aus Edelstahl besteht, der vorzugsweise unmagnetisch ist, um die Wirkung der Magnete nicht zu stören, kann ein robuster und einfach zu reinigender Bedienknebel bereitgestellt werden, der sich hinsichtlich des Designs gut in weitere Edelstahlelemente in einer Küche einfügen kann.

Eine starke Magnetkraft kann erreicht werden, wenn wenigstens eines der zumindest magnetisierbaren Elemente als Permanentmagnet ausgebildet ist. Die Formulierung "zumindest magnetisierbar" soll daher im Sinne von "magnetisierbar oder magnetisch" verstanden werden. Als "magnetisierbar" sollen in diesem Zusammenhang insbesondere paramagnetische Substanzen bezeichnet werden und als "magnetisch" sollen insbesondere ferromagnetische Substanzen bezeichnet werden.

Umfasst die Vorrichtung eine Anordnung zum induktiven Übertragen von elektromagnetischer Energie in den Bedienknebel, also beispielsweise einen im Bedienknebel angeordneten elektromagnetischen Schwingkreis mit einer Spule, die induktiv mit einer im Kochfeld angeordneten Spule gekoppelt ist, kann der Bedienknebel aktive Funktionen übernehmen, beispielsweise eine Beleuchtung und/oder ein Display umfassen. Denkbar wäre auch eine im Bedienknebel angeordnete Batterie als Alternative zu der Anordnung zum Übertragen von elektromagnetischer Energie in den Bedienknebel.

Wenn der Bedienknebel in einer Seitenfläche einen parallel zu der Standfläche verlaufenden Kunststoffring umfasst, kann eine Wärmeausdehnung der Hülle elegant kompensiert werden und der Kunststoffring kann als Designelement das Unterscheiden der Berührfläche von der Standfläche erleichtern.

Ferner geht die Erfindung aus von einem Kochfeld mit einer Detektorvorrichtung zum Detektieren einer Drehlage und/oder Drehbewegung eines durch eine Magnetkraft in einer vorgegebenen Position gehaltenen Bedienknebels, bezogen auf eine senkrecht zu einer Standebene des Bedienknebels verlaufende Rotationsachse.

Es wird vorgeschlagen, das Kochfeld mit einem Detektionsmittel zum Erkennen einer Richtung einer Kippbewegung des Bedienknebels um eine zumindest im Wesentlichen senkrecht zu der Rotationsachse verlaufende Kippachse auszustatten. Durch das Detektionsmittel wird eine Kippbewegung des Bedienknebels erfassbar und dadurch kann ein neuer Freiheitsgrad für gattungsgemäße, magnetisch auf dem Kochfeld gehaltene Bedienknebel erschlossen werden.

In einer Weiterbildung des Kochfelds wird vorgeschlagen, dass das Detektionsmittel zumindest einen, seitlich neben der vorgegebenen Position angeordneten, induktiven Näherungssensor umfasst. Dadurch kann die Kippbewegung konstruktiv besonders einfach erkennbar gemacht werden.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
Fig. 1 ein Kochfeld aus Glaskeramik mit einem Bedienknebel in einer perspektivischen Ansicht,
Fig. 2 den Bedienknebel einer Bedienvorrichtung des Kochfelds aus Figur 1 in einer Seitenansicht,
Fig. 3 den Bedienknebel aus Figur 2 auf dem Kochfeld in einer schematischen Schnittdarstellung in einer Ruheposition und
Fig. 4 den Bedienknebel und das Kochfeld aus Figur 3 in einer Kippposition zum Auswählen einer Kochzone.

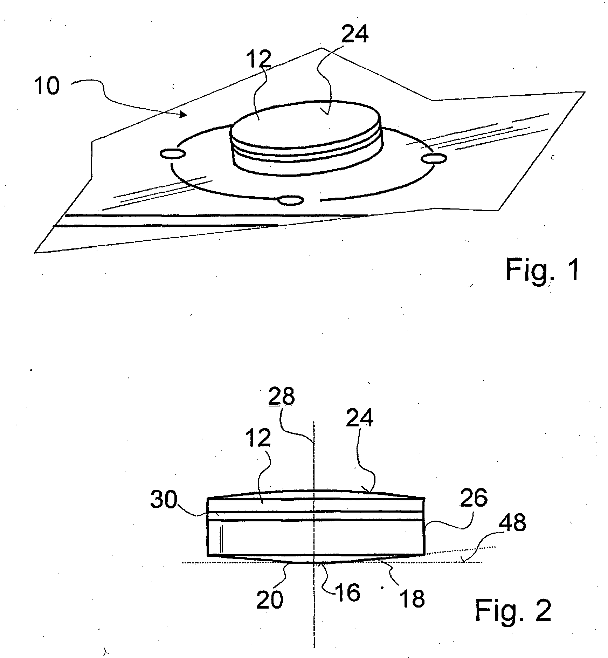

Figur 1 zeigt ein Kochfeld 10 mit einer Bedienvorrichtung für ein Kochfeld 10, die einen Bedienknebel 12 mit wenigstens einem zumindest magnetisierbaren Element 14 umfasst. Das zumindest magnetisierbare Element 14 dient zum Positionieren des Bedienknebels 12 an einer definierten Position des Kochfelds 10 durch eine Magnetkraft. Der Bedienknebel 12 umfasst eine sich in einer Standebene 48 erstreckende Standfläche 16 zum Abstützen auf dem Kochfeld 10 in einer Ruheposition.

Die Bedienvorrichtung bzw. der Bedienknebel 12 hat eine die Standfläche 16 umgebende Auflagefläche 18 zum Abstützen des Bedienknebels 12 in einer Kippposition, wobei die Auflagefläche 18 in der Ruheposition der Standebene 48 der Standfläche 16 zugewandt ist und von dieser überall außer an ihrem unmittelbar an die Standfläche 16 anschließenden inneren Rand beabstandet ist.

Die Auflagefläche 18 ist konvex zur Standebene 48 hin gewölbt und hat die Form eines axialsymmetrischen Ausschnitts aus einem trichterförmig nach unten zusammenlaufenden Kegelmantel. Die Standfläche 16 ist kreisförmig und eben und ergänzt die Oberfläche zu einem in der Ruheposition des Bedienknebels 12 nach unten gerichteten Kegelstumpf.

Die Form der Auflagefläche 18 entspricht der eines sehr flachen Kegels, da die Auflagefläche 18 bezogen auf die Standebene 48 einen Neigungswinkel von weniger als 10° hat. Im vorliegenden Ausführungsbeispiel beträgt der Neigungswinkel 6°. Die Auflagefläche 18 und die Standfläche 16 stoßen in einer kreisförmigen, stumpfwinkligen Kante 20 zusammen, die die Menge aller möglichen Auflagepunkte des Bedienknebels 12 während einer Kippbewegung von der Ruheposition in eine Kippposition und umgekehrt definiert. Die Kippbewegung ist eine Drehbewegung um eine Kippachse 22, die eine Tangente an die kreisförmige Kante 20 in dem entsprechenden Auflagepunkt ist. Die Kippachse 22 ist demnach senkrecht zur Symmetrieachse der kreisförmigen Kante 20 bzw. der Auflagefläche 18.

Die Kippbewegung um die gewählte Kippachse 22 wird dadurch begrenzt, dass nach einer Drehung um 6° die Auflagefläche 18 in einem von dem Auflagepunkt aus in der Auflagefläche 18 radial nach außen verlaufenden Linienkontakt mit dem Kochfeld 10 in Berührung tritt, so dass der Bedienknebel 12 nicht weiter verkippt werden kann.

Der Bedienknebel 12 hat zudem eine der Standfläche 16 gegenüberliegende Berührfläche 24, die um ein Vielfaches größer ist als die Standfläche 16 und die in der Ruheposition konvex nach oben gebogen ist, so dass der Bedienknebel 12 schon durch ein leichtes Berühren der Berührfläche 24 an ihrem Rand von der Ruheposition in die Kippposition gekippt werden kann.

Im dargestellten Ausführungsbeispiel beträgt der Durchmesser der Standfläche 16 10 mm und der Durchmesser der Berührfläche 24 beträgt 40 mm. Zwischen der Berührfläche 24 und der Auflagefläche 18 befindet sich eine Seitenfläche 26, die zylindermantelförmig ist und die gleiche Symmetrieachse hat wie die Standfläche 16, die Auflagefläche 18 und die Berührfläche 24. Die Berührfläche 24, die Seitenfläche 26, die Standfläche 16 und die Auflagefläche 18 bilden zusammen eine geschlossene Außenfläche des Bedienknebels 12, die um eine senkrecht zur Standfläche 16 verlaufende, der Symmetrieachse entsprechende Rotationsachse 28 rotationssymmetrisch ist.

Der Bedienknebel 12 weist einen in einer Seitenfläche 26 parallel zu der Standfläche 16 verlaufenden Kunststoffring 30 auf, der die Seitenfläche 26 in zwei unterschiedlich breite Ringe aufteilt, so dass für einen Bediener klar erkennbar ist, welche Seite des Bedienknebels 12 oben bzw. die Berührfläche 24 ist und welche Seite unten ist.

Da zwischen dem Kochfeld 10 aus Glaskeramik und der Außenhülle des Bedienknebels 12, die aus Edelstahl besteht, nur eine geringe Gleitreibung besteht, kann der Bedienknebel 12 in der Ruheposition leicht um die Rotationsachse 28 gedreht werden, wobei sich die Standfläche 16 auf dem Kochfeld 10 gleitend dreht.

Im Bedienknebel 12 sind eine Mehrzahl von gleichmäßig um die senkrecht zur Standfläche 16 verlaufende Rotationsachse 28 verteilten Magneten 32 angeordnet, die hier nur schematisch dargestellt sind. Figur 2 zeigt ebenfalls nur schematisch dargestellte HallSensoren 46, die im Kochfeld 10 das von dem Magneten 32 erzeugte Magnetfeld detektieren. Die Spannung der Hall-Sensoren 46 variiert daher beim Drehen mit einer Frequenz, die der Frequenz entspricht, mit welcher die Magnete 32 den entsprechenden Hall-Sensor passieren.

Das magnetisierbare Element 14, das zum Erzeugen der Magnetkraft und zum Halten des Bedienknebels 12 in der vorgegebenen Position auf dem Kochfeld 10 vorgesehen ist, ist mittig im unteren Bereich des Bedienknebels 12 angeordnet und ist als Permanentmagnet ausgebildet. Ein weiterer Permanentmagnet 34 mit gleicher Magnetisierungsrichtung ist in der vorgegebenen Position unterhalb einer Glaskeramikplatte 36 des Kochfelds 10 angeordnet und wirkt anziehend auf das magnetisierbare Element 14 bzw. den Permanentmagneten im Bedienknebel 12.

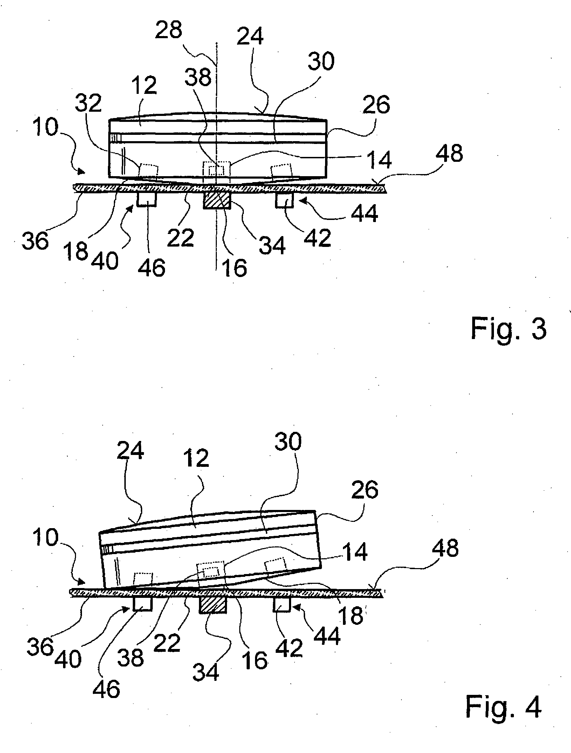

Die Magnetkraft zwischen dem magnetisierbaren Element 14 und dem starken Permanentmagneten 34 wirkt als Rückstellkraft, die den Bedienknebel 12 aus der in Figur 4 dargestellten Kippposition selbsttätig in die Ruheposition zurückstellt.

In einer alternativen Ausgestaltung der Erfindung kann die Bedienvorrichtung eine in Figur 3 gepunktet dargestellte Anordnung 38 zum induktiven, drahtlosen Übertragen von elektromagnetischer Energie in den Bedienknebel 12 umfassen, die beispielsweise eine im Bedienknebel 12 angeordnete Leuchtdiode mit Energie versorgen kann. Zum Herstellen eines beleuchteten Bedienknebels 12 kann der Kunststoffring 30 vorteilhaft aus transparentem Kunststoff ausgebildet sein.

Das Kochfeld 10 muss zur Verwendung des Bedienknebels 12 in der erfindungsgemäßen Weise mit einer Detektorvorrichtung 40 zum Detektieren einer Drehlage und/oder Drehbewegung eines durch eine Magnetkraft in einer vorgegebenen Position gehaltenen Bedienknebels 12, bezogen auf die senkrecht zu einer Standebene 48 des Bedienknebels 12 verlaufende Rotationsachse 28, ausgestattet sein.

Die Detektorvorrichtung 40 dient dem Erkennen einer Richtung einer Kippbewegung des Bedienknebels 12 um eine zumindest im Wesentlichen senkrecht zu der Rotationsachse 28 verlaufende Kippachse 22, und zwar durch induktive Näherungssensoren 42 eines Detektionsmittels 44 der Detektorvorrichtung 40, die in der Ruheposition seitlich neben der Standfläche 16 bzw. seitlich neben der vorgegebenen Position unterhalb der Glaskeramikplatte 36 des Kochfelds 10 angeordnet sind.

### Bezugszeichen

- 10: Kochfeld
- 12: Bedienknebel
- 14: Element
- 16: Standfläche
- 18: Auflagefläche
- 20: Kante
- 22: Kippachse
- 24: Berührfläche
- 26: Seitenfläche
- 28: Rotationsachse
- 30: Kunststoffring
- 32: Magnet
- 34: Permanentmagnet
- 36: Glaskeramikplatte
- 38: Anordnung
- 40: Detektorvorrichtung
- 42: Näherungssensor
- 44: Detektionsmittel
- 46: Hall-Sensor
- 48: Standebene

## Patentansprüche

1. Kochfeld (10) mit einer Detektorvorrichtung (40) zum Detektieren einer Drehlage und/oder Drehbewegung eines durch eine Magnetkraft in einer vorgegebenen Position gehaltenen Bedienknebels (12), bezogen auf eine senkrecht zu einer Standebene (48) des Bedienknebels (12) verlaufende Rotationsachse (28), mit einem Detektionsmittel (44) zum Erkennen einer Richtung einer Kippbewegung des Bedienknebels (12) um eine zumindest im Wesentlichen senkrecht zu der Rotationsachse (28) verlaufende Kippachse (22) und mit einer Bedienvorrichtung für das Kochfeld (10) in Form des Bedienknebels (12) mit wenigstens einem zumindest magnetisierbaren Element (14) zum Positionieren des Bedienknebels (12) an der definierten Position des Kochfelds (10) durch die Magnetkraft, **dadurch gekennzeichnet, dass** die Bedienvorrichtung eine sich in einer Standebene (48) erstreckende Standfläche (16) zum Abstützen auf dem Kochfeld (10) in einer Ruheposition, wobei die Standfläche (16) kreisförmig und eben ist, und eine die Standfläche (16) umgebende Auflagefläche (18) zum Abstützen des Bedienknebels (12) in einer Kippposition aufweist, wobei die Auflagefläche (18) in der Ruheposition der Standebene (48) der Standfläche (16) zugewandt ist und der Durchmesser der Standfläche (16) weniger als 20 mm beträgt.

2. Kochfeld (10) nach Anspruch 1, **dadurch gekennzeichnet, dass** die Auflagefläche (18) konvex zur Standebene (48) hin gewölbt ist.

3. Kochfeld (10) nach Anspruch 2, **dadurch gekennzeichnet, dass** die Auflagefläche (18) die Form eines Ausschnitts aus einem Kegelmantel hat.

4. Kochfeld (10) nach Anspruch 3, **dadurch gekennzeichnet, dass** die Auflagefläche (18) bezogen auf die Standebene (48) einen Neigungswinkel von weniger als 10° hat.

5. Kochfeld (10) nach einem der vorhergehenden Ansprüche, **gekennzeichnet durch** eine der Standfläche (16) gegenüberliegende Berührfläche (24), die um ein Vielfaches größer ist als die Standfläche (16).

6. Kochfeld (10) nach einem der vorhergehenden Ansprüche, **dadurch gekennzeichnet, dass** zumindest die Außenfläche des Bedienknebels (12) um eine senkrecht zur Standfläche (16) verlaufende Rotationsachse (28) rotationssymmetrisch ist.

7. Kochfeld (10) nach einem der vorhergehenden Ansprüche, **gekennzeichnet durch** eine Mehrzahl von gleichmäßig um eine senkrecht zur Standfläche (16) verlaufende Rotationsachse (28) verteilten Magneten (32).

8. Kochfeld (10) nach einem der vorhergehenden Ansprüche, **dadurch gekennzeichnet, dass** zumindest die Außenhülle des Bedienknebels (12) aus Edelstahl besteht.

9. Kochfeld (10) nach einem der vorhergehenden Ansprüche, **dadurch gekennzeichnet, dass** wenigstens eines der zumindest magnetisierbaren Elemente (14) als Permanentmagnet ausgebildet ist.

10. Kochfeld (10) nach einem der vorhergehenden Ansprüche, **gekennzeichnet durch** eine Anordnung (38) zum induktiven Übertragen von elektromagnetischer Energie in den Bedienknebel (12).

11. Kochfeld (10) nach einem der vorhergehenden Ansprüche, **dadurch gekennzeichnet, dass** der Bedienknebel (12) in einer Seitenfläche (26) einen parallel zu der Standfläche (16) verlaufenden Kunststoffring (30) umfasst.

12. Kochfeld (10) nach einem der vorhergehenden Ansprüche, **dadurch gekennzeichnet, dass** das Detektionsmittel (44) zumindest einen, seitlich neben der vorgegebenen Position angeordneten, induktiven Näherungssensor (42) umfasst.

## Claims

1. Cooktop (10) having a detector device (40) for detecting a rotational position and/or rotational movement of a control toggle (12) held in a predefined position by means of a magnetic force, referred to an axis of rotation (28) running perpendicular to a base plane (48) of the control toggle (12), with a detection means (44) for detecting a direction of a tilting movement of the control toggle (12) about a tilt axis (22) running at least substantially perpendicular to the axis of rotation (28) and with a control device for the cooktop (10) in the form of the control toggle (12) with at least one at least magnetisable element (14) for positioning the control toggle (12) at a defined position of the cooktop (10) by means of the magnetic force, **characterised in that** the control device has a base surface (16) extending in a base plane (48) for the purpose of providing support on the cooktop (10) in a home position, wherein the base surface (16) is circular and level, and **has** a bearing surface (18) surrounding the base surface (16) for the purpose of supporting the control toggle (12) in a tilt position, wherein in the home position the bearing surface (18) faces toward the base surface (16) of the base plane (48) and the diameter of the base surface (16) is less - than 20 mm.

2. Cooktop (10) according to claim 1, **characterised in that** the bearing surface (18) is curved in a convex manner toward the base plane (48).

3. Cooktop (10) according to claim 2, **characterised in that** the bearing surface (18) has the shape of a section from a cone envelope.

4. Cooktop (10) according to claim 3, **characterised in that** the bearing surface (18) has an angle of inclination of less than 10° referred to the base plane (48).

5. Cooktop (10) according to one of the preceding claims, **characterised by** a contact surface (24) disposed opposite the base surface (16) and a multiple greater in terms of size than the base surface (16).

6. Cooktop (10) according to one of the preceding claims, **characterised in that** at least the outer surface of the control toggle (12) is rotationally symmetrical about an axis of rotation (28) running perpendicular to the base surface (16).

7. Cooktop (10) according to one of the preceding claims, **characterised by** a plurality of magnets (32) distributed uniformly around an axis of rotation (28) running perpendicular to the base surface (16).

8. Cooktop (10) according to one of the preceding claims, **characterised in that** at least the outer shell of the control toggle (12) consists of stainless steel.

9. Cooktop (10) according to one of the preceding claims, **characterised in that** at least one of the at least magnetisable elements (14) is embodied as a permanent magnet.

10. Cooktop (10) according to one of the preceding claims, **characterised by** an arrangement (38) for inductively transmitting electromagnetic energy into the control toggle (12).

11. Cooktop (10) according to one of the preceding claims, **characterised in that** in a side surface (26) the control toggle (12) includes a plastic ring (30) running parallel to the base surface (16).

12. Cooktop (10) according to one of the preceding claims, **characterised in that** the detection means (44) includes at least one inductive proximity sensor (42) arranged laterally next to the predefined position.

## Revendications

1. Plaque de cuisson (10) comprenant un dispositif détecteur (40) destiné à détecter une position tournée et/ou un mouvement de rotation d'un bouton de commande (12) maintenu dans une position prédéfinie au moyen d'une force magnétique, par rapport à un axe de rotation (28) s'étendant perpendiculairement à un plan d'appui (48) du bouton de commande (12), comprenant un moyen de détection (44) destiné à identifier une direction d'un mouvement de bascule du bouton de commande (12) autour d'un axe de bascule (22) s'étendant au moins essentiellement perpendiculairement à l'axe de rotation (28) et comprenant un dispositif de commande pour la plaque de cuisson (10) sous forme du bouton de commande (12) muni au moins d'un élément (14) au moins magnétisable, destiné à positionner le bouton de commande (12) sur la position définie de la plaque de cuisson (10) au moyen de la force magnétique, **caractérisée en ce que** le dispositif de commande présente une surface d'appui (16) s'étendant dans un plan d'appui (48), destinée à l'appui sur la plaque de cuisson (10) dans une position de repos, la surface d'appui (16) étant circulaire et plane, et **en ce qu'**il présente une surface de pose (18) entourant la surface d'appui (16), destinée à l'appui du bouton de commande (12) dans une position de bascule, la surface de pose (18), en position de repos du plan d'appui (48), étant tournée vers la surface d'appui (16) et le diamètre de la surface d'appui (16) étant inférieur à 20 mm.

2. Plaque de cuisson (10) selon la revendication 1, **caractérisée en ce que** la surface de pose (18) est courbée de manière convexe en direction du plan d'appui (48).

3. Plaque de cuisson (10) selon la revendication 2, **caractérisée en ce que** la surface de pose (18) a la forme d'une partie d'une enveloppe de cône.

4. Plaque de cuisson (10) selon la revendication 3, **caractérisée en ce que** la surface de pose (18), par rapport au plan d'appui (48), a un angle d'inclinaison de moins de 10°.

5. Plaque de cuisson (10) selon l'une quelconque des revendications précédentes, **caractérisée par** une surface de contact (24) opposée à la surface d'appui (16), laquelle surface de contact est supérieure d'un multiple à la surface d'appui (16).

6. Plaque de cuisson (10) selon l'une quelconque des revendications précédentes, **caractérisée en ce qu'**au moins la surface extérieure du bouton de commande (12) est symétrique en rotation autour d'un axe de rotation (28) s'étendant perpendiculairement à la surface d'appui (16).

7. Plaque de cuisson (10) selon l'une quelconque des revendications précédentes, **caractérisée par** une pluralité d'aimants (32) répartis régulièrement autour d'un axe de rotation (28) s'étendant perpendiculairement à la surface d'appui (16).

8. Plaque de cuisson (10) selon l'une quelconque des revendications précédentes, **caractérisée en ce qu'**au moins l'enveloppe extérieure du bouton de commande (12) est constituée d'acier inoxydable.

9. Plaque de cuisson (10) selon l'une quelconque des revendications précédentes, **caractérisée en ce qu'**au moins un des éléments (14) au moins magnétisables est réalisé comme aimant permanent.

10. Plaque de cuisson (10) selon l'une quelconque des revendications précédentes, **caractérisée par** un agencement (38) pour le transfert inductif d'énergie électromagnétique dans le bouton de commande (12).

11. Plaque de cuisson (10) selon l'une quelconque des revendications précédentes, **caractérisée en ce que** le bouton de commande (12), dans une surface latérale (26), comprend une bague plastique (30) s'étendant parallèlement à la surface d'appui (16).

12. Plaque de cuisson (10) selon l'une quelconque des revendications précédentes, **caractérisée en ce que** le moyen de détection (44) comprend au moins un capteur de proximité inductif (42) disposé latéralement à côté de la position prédéfinie.
